Europäisches Patentamt

European Patent Office

Office européen des brevets

(19)

(11) **EP 0 483 125 B1**

(12) **EUROPEAN PATENT SPECIFICATION**

(45) Date of publication and mention
of the grant of the patent:
**03.04.1996 Bulletin 1996/14**

(51) Int Cl.6: **G05F 3/24**, G05F 3/26

(21) Application number: **92200259.7**

(22) Date of filing: **30.06.1988**

(54) **Current-source**

Stromquelle

Source de courant

(84) Designated Contracting States:
**BE CH DE IT LI**

(43) Date of publication of application:
**29.04.1992 Bulletin 1992/18**

(62) Application number of earlier application in
accordance with Art. 76 EPC: **88905804.6**

(73) Proprietors:
• **BELL TELEPHONE MANUFACTURING
COMPANY Naamloze Vennootschap
B-2018 Antwerp (BE)**
Designated Contracting States:
**BE**
• **ALCATEL N.V.
NL-2288 BH Rijswijk (NL)**
Designated Contracting States:
**CH DE IT LI**

(72) Inventors:
• **Sevenhans, Joannes Mathilda Josephus
B-2930 Brasschaat (BE)**
• **Guebels, Pierre-Paul François Maurice Marie
B-2650 Edegem (BE)**

(56) References cited:
**DE-A- 3 242 417**          **US-A- 4 287 438**

• **IBM TECHNICAL DISCLOSURE BULLETIN. vol.
14, no. 7, December 1971, NEW YORK US pages
2088 - 2089 ASKIN ET AL. 'FET Device
Parameters Compensation Circuit'**
• **IEEE TRANSACTIONS ON CIRCUITS AND
SYSTEMS vol. CAS27, no. 6, June 1980, pages
527 - 538 FETTWEIS ET AL. 'MOS
Switched-Capacitor Filters Using Voltage
Inverter Switches**
• **PATENT ABSTRACTS OF JAPAN vol. 8, no. 169
(P-292)(1606) 4 August 1984 & JP-A-59 062926**

## Description

The present invention relates to a current source including a first branch constituted by the series connection of a diode-connected first transistor of a first polarity type and a control second transistor of a second polarity type, the control electrode of said first transistor being connected to that of a third transistor of said first polarity type, and a bias circuit associated to said control second transistor for maintaining constant the current flowing therethrough and thereby the current flowing through said third transistor.

Such a current source using a current mirror configuration is already known in the art, e.g. from the article " MOS Switched-Capacitor Filters Using Voltage Inverter Switches" by A. Fettweis et al, published in the "IEEE TRANSACTIONS ON CIRCUITS AND SYSTEMS", VOL. CAS-27, NO.6, JUNE 1980, pages 527 to 538. In Fig. 15 thereof, the first branch comprises a diode-connected first NMOS transistor T3 connected in series with two series connected PMOS transistors T1 and T2, the third transistor being the NMOS transistor T6. The two series connected PMOS transistors T1 and T2 are each diode-connected so that they can be seen as a single diode connected second transistor. In this known current source, the current flowing through the first transistor, and thus also through the second transistor in series therewith, is mirrored in the third transistor. This current flowing through the first transistor is maintained constant by the fact that the second transistors as well as the first transistor are diode-connected. These second transistors can thus be seen as forming part of the bias circuit of the current source. When such a current source has to be produced at a large production scale, it is not easy to reproduce exactly the controlled current flowing through the third transistor, i.e. to maintain this current constant from one production process to another. Indeed, this current is not only dependent on the voltage at the control electrode of the third transistor but also on the parameters of all the transistors, especially their threshold voltages which are not easy to match for transistors of opposite polarity types in each production process. In more detail, any change of the threshold voltage of either the first or the second transistor, or both, leads to a modification of the constant current in the third transistor.

An object of the present invention is to provide a current source of the above known type but wherein the current flowing through the third transistor is independent of the threshold voltages of the constituent transistors of the current source.

According to the invention, this object is achieved due to the fact that said bias circuit is formed by a second branch coupled in parallel with said first branch and constituted by the series connection of a fourth, fifth, sixth and seventh transistors all of said second polarity type, the control electrode of said fifth transistor being connected to that of said control second transistor.

Because in a same production process all the threshold voltages of the transistors of a same conductivity type are equal, the voltage at the control electrode of the fifth transistor and thus also at that of the second transistor is constant for each production process. As a result, the current flowing through the second transistor which is no more diode-connected as in the above prior art is maintained constant. This constant current flows also-through the first transistor and is mirrored in the third transistor via the interconnected control electrodes of these first and third transistors. Because on the one hand the voltage at the latter control electrodes is dependent on the threshold voltage of the first transistor, and on the other hand the first and third transistors are of the same polarity type and thus have the same threshold voltage, any variation of the voltage at their control electrodes has no effect on the relation between the currents flowing through the first and the third transistors. As a consequence, the current flowing through the third transistor is constant because the current flowing through the first transistor is also constant. Simulations have confirmed the expected results.

Another characteristic feature of the current source according to the invention is that all said transistors are MOS transistors, that said fourth and seventh transistors are substantially identical, that said fifth and sixth transistors are substantially identical, that said control electrodes are the gate electrodes of the MOS transistors, and that the Width-by-Length W/L channel parameter of said fifth and sixth transistors is relatively much larger than that of said fourth and seventh transistors.

Still another characteristic feature of the current source of the present invention is that said fourth to seventh transistors are all diode-connected.

The above mentioned and other objects and features of the invention will become more apparent and the invention itself will be best understood by referring to the following description of an embodiment taken in conjunction with the accompanying drawings in which :

Fig. 1 shows a signal comparator including a current source BS according to the invention and associated to a bistate device ST, an input circuit IC and a bistable device FF; and
Figs. 2 to 5 show various signal waveforms appearing at terminals of the signal comparator of Fig. 1.

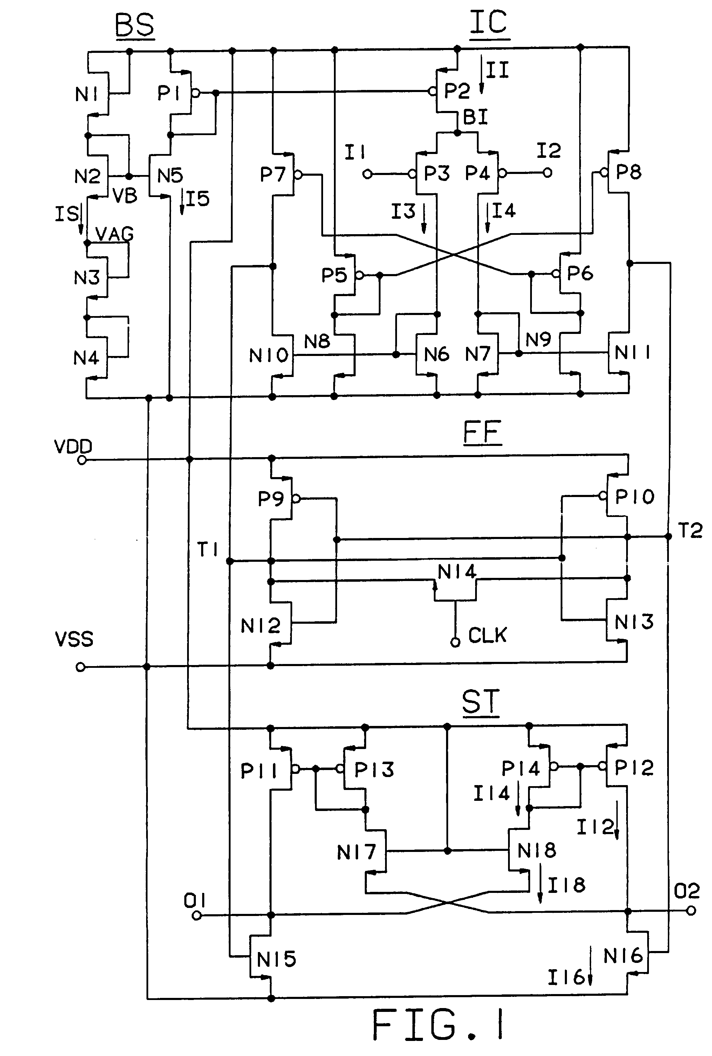

The signal comparator shown in Fig. 1 is a double ended circuit which is for instance used as a one bit analog to digital converter forming part of the last stage of a sigma-delta modulator and able to provide differential Pulse Density Modulated (PDM) output signals. It has differential input terminals I1 and I2 and differential output terminals O1 and O2 providing like named complementary output signals respectively. The comparator is connected to a power supply (not shown) which provides the supply voltages VSS of 0 Volts (ground) and VDD of 5 Volts, and to a clock signal generator CLK supplying a clock signal, e.g. of 15.36 MegaHertz, all these signals being applied to the comparator via respective like named terminals. The comparator comprises four stages all connected to the supply voltages VDD and VSS:

- a current source or bias source BS including NMOS transistors N1 to N5 and PMOS transistors P1 and P2, and having an output terminal BI;
- an input circuit IC including NMOS transistors N6 to N11 and PMOS transistors P3 to P8, whose input terminals I1 and I2 are those of the comparator, which has the input current supply terminal BI connected to the bias source BS, and which has output terminals T1 and T2;
- a bistable device or flipflop circuit FF including NMOS transistors N12, N13 and N14 and PMOS transistors P9 and P10 and to which the clock terminal CLK and the output terminals T1 and T2 of the input device IC are connected; and
- a bistate device or Schmitt trigger ST including NMOS transistors N15 to N18 and PMOS transistors P11 to P14, to which the output terminals T1 and T2 of the input circuit IC are also connected, its output terminals O1 and O2 being those of the comparator.

It is to be noted that the PMOS transistors have generally their source electrode connected to the most positive voltage terminal, e.g. VDD, whilst the NMOS transistors have generally their source electrode connected to the less positive voltage terminal, e.g. VSS. Moreover, a transistor having its gate and drain electrodes interconnected is called hereinafter a diode connected transistor.

The bias source BS includes two parallel branches between the voltage supply terminals VDD and VSS. A first branch includes the diode connected transistors N1 to N4 in series and the second branch includes the series connection of the diode connected transistor P1 and the drain-to-source path of the transistor N5 of which the gate electrode is connected to that of the transistor N2 of the first branch in a current mirror configuration. The gate and the drain electrodes of the transistor P1 are both connected the gate electrode of the transistor P2 feeding the input circuit IC. The transistor P2 has its drain electrode connected to the output terminal BI of the bias source BS and so further to the like named input current supply terminal of the input circuit IC for which this transistor P2 constitutes a constant current source.

The input circuit IC includes six branches coupled between the voltage supply terminals VDD and VSS. The first two of these branches are each constituted by the series connection of the source-to-drain path of the transistor P3/P4 and the diode connected transistor N6/N7. The source electrode of the transistor N6/N7 is connected to the voltage supply terminal VSS whilst the voltage supply terminal VDD is connected to both these two branches via the commonly used current source P2. The input terminals I1 and I2 are connected to the gate electrodes of the transistors P3 and P4 respectively. Two other branches are constituted by the series connection of the diode connected transistor P5/P6 and the drain-to-source path of the transistor N8/N9, and the two last branches are constituted by the series connection of source-to-drain path of the transistor P7/P8 and the drain-to-source path of the transistor N10/N11. The branches P5, N8 and P6, N9 are used in current mirror configuration with the branches P2, P3, N6 and P2, P4, N7 respectively. Both the pairs of transistors P5, N9 and P6, N8 control in a complementary way the pairs of transistors P8, N11 and P7, N10 respectively. The junction points between the drain electrodes of the transistors P7 and N10 and of the transistors P8 and N11 are used as respective input terminals T1 and T2 for the flipflop circuit FF as well as for the Schmitt trigger ST.

The flip flop circuit FF includes between the voltage supply terminals VDD and VSS two parallel branches each comprising the series connection of the source-to-drain path of the transistor P9/P10 and the drain-to-source path of the transistor N12/N13. The terminal T1/T2 is connected to the junction point of the drain electrodes of the transistors P9/P10 and N12/N13 as well as to the interconnected gate electrodes of the transistors P10/P9 and N13/N12 respectively. The terminal T1 is further coupled to the terminal T2 via the source-to-drain path of the transistor N14 of which the gate electrode is controlled by the clock signal CLK applied thereto via the like named clock terminal.

The bistate device or Schmitt trigger ST includes between the voltage supply terminals VDD and VSS two parallel branches each comprising the series connection of the source-to-drain path of the transistor P11/P12 and the drain-to-source path of the transistor N15/N16. The terminal T1/T2 is connected to the gate electrode of the transistor N15/N16 whilst the junction point of the drain electrodes of the transistors P11/P12 and N15/N16 is connected to the output terminal O1/O2. ST further includes between the voltage supply terminal VDD and the output terminal O2 the series connection of the diode connected transistor P13 and the drain-to-source path of the transistor N17, and between this voltage supply terminal VDD and the output terminal O1 the series connection of the diode connected transistor P14 and the drain-to-source path of the transistor N18. The gate electrodes of the transistors N17 and N18 are both connected to the voltage supply terminal VDD whilst the gate and drain electrodes of the transistors P13 and P14 are connected to the gate electrodes of the transistors P11 and P12 respectively in a current mirror configuration.

The purpose of the bias source BS is to maintain a constant current II through the source-to-drain path of the transistor P2 which constitutes the current source of the input circuit IC as already mentioned. The latter IC is a double ended differential amplifier forming the analog input part of the comparator and which receives via its differential input terminals I1 and I2 the analog output signals from the preceding stage of the sigma-delta modulator (not shown). The input circuit IC provides at its differential output terminals T1 and T2 respective analog output signals which are applied to the flipflop circuit circuit FF. According to the relative amplitude of the signals VT1 and VT2 at the respective terminals T1 and T2, the flipflop circuit FF is set in a state which clamps in a complementary way these signals VT1 and VT2 either to the voltage VSS or to the voltage VDD thus providing to the differential input terminals T1 and T2 of the Schmitt trigger ST the logical levels 0 or 1 respectively.

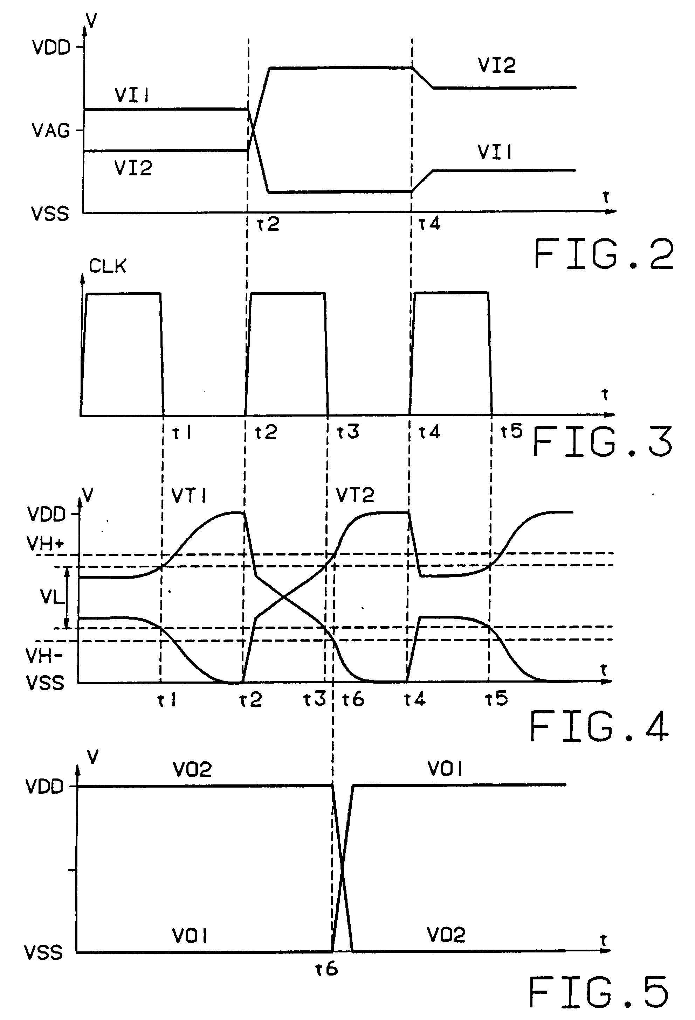

It is to be noted that for each positive value of the clock signal CLK (Fig. 3), the terminals T1 and T2 are almost short-circuited via the transistor N14. At that moment, unless it is to change following a reversal of the input conditions, the previous state of the flipflop circuit FF is latched owing to the hysteresis function of the Schmitt trigger ST.

The operation of the comparator is explained more in detail hereinafter by making reference to an example illustrated by the waveform signals shown in the Figs. 2 to 5.

First, the bias source BS is described. The purpose of this bias source BS is to provide a current II flowing through the source-to-drain path of the transistor P2 which is independent of the threshold voltages VTn and VTp of any NMOS and PMOS transistors respectively forming part of this bias source BS. Since the current II is a mirror copy of the current I5 flowing through the diode connected transistor P1 and also through the drain-to-source path of the transistor N5 connected in series therewith, it is necessary to obtain that the current I5 is independent of VTn and VTp.

The current I5 is equal to

$$I5 = (mn * Cox/2) * (W5/L5) * (Vgs5 - VTn) ** 2 \qquad (1)$$

wherein

*      is the multiplication sign for the adjoining terms;
**      precedes the exponent for the previous term;
mn      is the mobility of the charge carriers;
Cox      is the capacity of the oxide;
VTn      is the threshold voltage;
W5      is the width of the channel of the transistor N5;
L5      is the length of the channel of the transistor N5; and
Vgs5      is the gate-to-source voltage of the transistor N5 which is equal to

$$Vgs5 = VB - VSS \qquad (2)$$

wherein

VB     is the bias voltage at the interconnected gate electrodes of the transistors N5 and N2.

It is to be noted that the parameters mn, Cox and the threshold voltages VTn are almost identical for all the NMOS transistors built on a same chip. The above equation (1) may for instance be found in the book "INTRODUCTION TO VLSI SYSTEMS" by C. MEAD et al published by "ADDISON-WESLEY PUBLISHING COMPANY", chapter 1.1 "MOS Devices and Circuits", page 5.

In this bias source BS, the transistor N1 is chosen identical to the transistor N4 and the transistor N2 is chosen identical to the transistor N3. One may thus write

$$W1/L1 = W4/L4 \qquad (3)$$

and

$$W2/L2 = W3/L3 \qquad (4)$$

wherein

W1, W2, W3 and W4     are the widths of the channels of the transistors N1, N2, N3 and N4 respectively; and
L1, L2, L3 and L4     are the lengths of the channels of the transistors N1, N2, N3 and N4 respectively.

Furthermore, the construction of these transistors is such that

$$W2/L2 = N * (W1/L1) \qquad (5)$$

and thus

$$W3/L3 = N * (W4/L4) \qquad (6)$$

wherein

N     is a proportionality factor.

On the one hand, the current I1 flowing through the diode connected transistor N1 is equal to

$$I1 = (mn*Cox/2) * (W1/L1) * (Vgs1 - VTn)**2 \qquad (7)$$

wherein

W1  is the width of the channel of the transistor N1;
L1   is the length of the channel of the transistor N1; and

Vgs1 is the gate-to-source voltage of the transistor N1 which is equal to

$$Vgs1 = VDD - VB \qquad (8)$$

Thus

$$I1 = (mn*Cox/2) * (W1/L1) * (VDD-VB-VTn)**2 \qquad (9)$$

On the other hand, the current I2 flowing through the diode connected transistor N2 is equal to

$$I2 = (mn*Cox/2) * (W2/L2) * (Vgs2 - VTn)**2 \qquad (10)$$

wherein

W2     is the width of the channel of the transistor N2;
L2     is the length of the channel of the transistor N2; and
Vgs2   is the gate-to-source voltage of the transistor N1 which is equal to

$$Vgs2 = VB - VAG \qquad (11)$$

wherein

VAG  is the voltage at the junction point between the source electrode of the transistor N2 and the drain and gate electrodes of the transistor N3.

Thus

$$I2 = (mn*Cox/2) * (W2/L2) * (VB-VAG-VTn)**2 \qquad (12)$$

The equation (12) combined with the equation (5) may be written

$$I2 = (mn*Cox/2) *N*(W1/L1)* (VB-VAG-VTn)**2 \qquad (13)$$

Because the four diode connected transistors N1 to N4 are in series a same current IS flows through the drain-to-source paths. Therefore, with I1 and I2 each equal to IS, the equations (9) and (13) then lead to

$$(VDD-VB-VTn)*2 = N * (VB-VAG-VTn)**2 \qquad (14)$$

By choosing the proportionality coefficient N large, this is solved by the physically acceptable approximation

$$VB = VAG + VTn \qquad (15)$$

which, used in equation (2), causes equation (1) to become

$$I5 = (mn*Cox/2) * (W5/L5) * (VAG - VSS)**2 \qquad (16)$$

This last form shows that the current I5 and thus also the current II which is a mirror copy thereof - with or without a proportionality coefficient - is independent of the threshold voltages VTn and VTp of the transistors of the bias source BS when the coefficient N is chosen sufficiently large. This means that the transistors N2 and N3 are much greater than the transistors N1 and N4.

Fig. 2 shows an example of differential input voltage waveforms VI1 and VI2 respectively applied to the input terminals I1 and I2 of the input circuit IC. Up to the instant t2, the voltage VI1 is more positive than the voltage VI2. At this instant t2, the amplitudes of these voltages VI1 and VI2 are modified so that the voltage VI2 then becomes more positive than the voltage VI1. At the instant t4 on Fig. 2, the amplitudes of these voltages VI1 and VI2 again change but the amplitude of the voltage VI2 remains higher than that of the voltage VI1.

As long as the voltage VI1 is more positive than the voltage VI2, i.e. before t2, the transistor P4 is more conductive than the transistor P3. The current I4 flowing through the transistor P4 is then larger than the current I3 flowing through the transistor P3, although the sum of these currents I4 and I3 remains equal to the current II flowing through the transistor P2. These currents I4 and I3 are mirrored to the other branches of the input circuit IC via the diode connected transistors N7 and N6 respectively. As a result the transistors N9, N11, P6 and P7 are more conductive than the transistors N8, N10, P5, and P8. As shown in Fig. 4, the voltage VT1 at the terminal T1 is then more positive than the voltage VT2 at the terminal T2.

As long as the clock signal CLK shown in Fig. 3 is high, the transistor N14 of the flipflop circuit FF is closed so that the terminals T1 and T2 are then almost short-circuited by this transistor N14. This appears in Fig. 4 where prior to the instant t1 at which the clock signal CLK becomes low, the voltages VT1 and VT2 are forced within a voltage range VL located near the average voltage VAG of 2.5 Volts. However, due to the voltage VT1 being more positive than the voltage VT2, the transistors N13 and P9 of the flipflop circuit FF are more conductive than the transistors N12 and P10 thereof. This anticipates the next coming state of this flipflop circuit FF which will be effective when the clock signal CLK is low, i.e. between the instants t1 and t2 in Fig. 3. From this instant t1, the transistor N14 becomes blocked so that the flipflop circuit FF may bring the terminals T1 and T2 to the respective voltages VDD (5 Volts) and VSS (0 Volts), i.e. to the logical levels 1 and 0 respectively. The variation of these voltages VT1 and VT2 to these logical levels occurs slowly because until the instant t2 the relative amplitudes of the input voltages VI1 and VI2 are low with respect to that of the average voltage VAG and that the flipflop circuit FF has to overwin these input voltages VI1 and VI2 and lead them to the extreme values of VDD and VSS respectively.

At t2, the clock signal CLK is again high as a consequence of which the amplitudes of the voltages VT1 and VT2 are brought within the voltage range VL. Because after t2, the amplitude of the input voltage VI1 becomes lower than that of the voltage VI2, the flipflop circuit FF has to change its state. This occurs while the clock signal is high, i.e. between t2 and t3. When the clock signal CLK becomes low at the instant t3, the amplitude of the voltages VT1 and VT2 are already inverted but both remain within the voltage range VL. From the instant t3, the amplitude of the voltages VT1 and VT2 rapidly reach their respective final amplitudes or logical levels 0 and 1. This variation occurs faster than that previously described because the difference of the input voltages VI1-VI2 is now greater (Fig. 2), i.e. closer to the difference of the supply voltages VDD-VSS.

At the instant t4, when the clock signal CLK becomes high, the amplitudes of the voltages VT1 and VT2 are again brought within the voltage range VL but because the input voltage VI2 now remains more positive than the input voltage VI1, the same is true for the respective voltages VT2 and VT1. When the clock signal CLK becomes low at the instant t5, the voltages VT1 and VT2 return to their respective previous logical levels, i.e. to the logical level they had before t4. Since the relative amplitudes of the input voltages VI1 and VI2 with respect to that of the average voltage VAG are now relatively lower than these before t4 (fig. 2), the voltages VT1 and VT2 vary a little slower.

The purpose of bringing the two voltages VT1 and VT2 back to a neutral value, i.e. within the voltage range VL, at each high clock signal CLK is to reduce the transition time when the flipflop circuit FF changes state. Indeed, when for instance the input voltage VI1 was more positive than the input voltage VI2 and that this situation is changed, at the following occurence of a low clock signal CLK the voltages VT1 and VT2 have then only to vary by 2.5 Volts (VDD-VAG or VAG-VSS) instead of 5 Volts (VDD-VSS).

The voltage range VL is so chosen that it is within the hysteresis voltage range from VH- to VH+ (Fig. 4) of the Schmitt trigger ST. In this way, the Schmitt trigger ST remains in its previous state as long as the amplitude of the voltage VT1 or VT2 which was the less positive does not exceed the upper value of the hysteresis voltage range VH+. Then, the output voltages VO1 and VO2 at the output terminals O1 and O2 switch from the logical levels 0 to 1 and vice versa. In the present example, such a variation only occurs at the instant t2 and the state of the Schmitt trigger ST shown in Fig. 5 only changes at the instant t6 - after t3 - when the amplitude of the voltage VT2 increases up to the upper hysteresis voltage VH+ and the amplitude of the voltage VT1 becomes lower than the hysteresis voltage VH-.

More in detail, when the amplitude of the voltage VT1 is relatively larger than that of the voltage VT2 and it exceeds the hysteresis voltage VH+, the transistors N15 and P12 are more conductive than the transistors N16 and P11. As a result, the voltage V01 at the terminal 01 is at the logical level 0, and the voltage V02 at the terminal 02 is at the logical level 1. In other words, the voltage V02 at the output terminal 02 is at the logical level 1 when the current I12 flowing through the source-to-drain path of the transistor P12 is greater than the current I16 flowing through the drain-to-source path of the transistor N16. The switching of the Schmitt trigger ST occurs when the current I12 is equal to the current I16. It is obvious that by symmetry the same reasoning may be made for the currents flowing through the transistors P11 and N15.

The present Schmitt trigger ST is so built that this transition point, i.e. when the current I12 becomes equal to the current I16, is known with accuracy and is independent of the construction or process parameters of the constituent transistors. Indeed, by construction

$$W12/L12 = A * (W14/L14) \tag{17}$$
$$W16/L16 = B * (W18/L18) \tag{18}$$

wherein

A and B     are proportionality coefficients both greater than 1;
W12, W14, W16 and W18     are the widths of the channels of the transistors P12, P14, N16 and N18 respectively; and
L12, L14, L16 and L18     are the lengths of the channels of the transistors P12, P14, N16 and N18 respectively.

The current I12 is controlled by the transistor N18 of which the drain-to-source current I18 is mirrored to the transistor P12 via the diode connected transistor P14. The gate-to-source voltage Vgs18 of the transistor N18 is equal to

$$Vgs18 = VDD - VO1 \tag{19}$$

and its drain-to-source current I18 is thus equal to

$$I18 = (mn*Cox/2)*(W18/L18)*(VDD-VO1-VTn)**2 \tag{20}$$

Since the transistors N18 and P14 are in series, the drain-to-source current I14 of the transistor P14 is equal to the current I18, and because of the relation (17) one may write

$$I12 = I14 * A = I18 * A \tag{21}$$
$$I12 = (mn*Cox/2)*(W18/L18)* A *(VDD-VO1-VTn)**2 \tag{22}$$

or, combined with the relation (18) to have I12 in function of W16 and L16

$$I12 = (mn*Cox/2)*(W16/L16)*A/B*(VDD-VO1-VTn)**2 \tag{23}$$

On the other hand, the gate-to-source voltage Vgs16 of the transistor N16 is equal to

$$Vgs16 = VT2 - VSS \tag{24}$$

and its drain-to-source current I16 is equal to

$$I16 = (mn*Cox/2)*(W16/L16)*(VT2-VSS-VTn)**2 \tag{25}$$

It is to be noted that the current I16 increases with the voltage VT2.

From the equations (23) and (25), it appears that at the transition point of the Schmitt trigger ST these currents I12 and I16 are both independent of the parameters mp and of the threshold voltage VTp of any PMOS transistor, more especially of the transistor P12. Furthermore, by equating the currents I12 and I16, this transition point is also shown to be independent of the parameter mn of any NMOS transistor and of the parameter Cox. Finally, by a suitable choice of the proportionality coefficients A and B, the equations (23) and (25) may become, in a first approximation, almost independent of the threshold voltage VTn of any NMOS transistor. Indeed, these coefficients may be so chosen that any variation of the threshold voltage VTn affects almost in a same way the values of both the currents I12 and I16 so that such a variation is compensated.

Because the operational characteristics of this Schmitt trigger ST are substantially independent of the process parameters of the constituent transistors thereof, identical circuits can be produced on a large scale.

While the principles of the invention have been described above in connection with specific apparatus, it is to be clearly understood that this description is made only by way of example and not as a limitation on the scope of the invention.

## Claims

1. Current source (BS) including a first branch (P1, N5) constituted by the series connection of a diode-connected first transistor (P1) of a first polarity type (P) and a second control transistor (N5) of a second polarity type (N), the control electrode of said first transistor (P1) being connected to that of a third transistor (P2) of said first polarity type (P), and a bias circuit (N1, N2, N3, N4) associated to said second control transistor (N5) for maintaining constant the current flowing therethrough and thereby the current flowing through said third transistor (P2), characterized in that said bias circuit is formed by a second branch (N1 to N4) coupled in parallel with said first branch (P1, N5) and constituted by the series connection of a fourth (N1), fifth (N2), sixth (N3) and seventh (N4) transistors all of said second polarity type (N), the control electrode of said fifth transistor (N2) being connected to the control electrode of said second control transistor (N5).

2. Current source (BS) according to claim 1, characterized in that all said transistors are MOS transistors, that said fourth (N1) and seventh (N4) transistors are substantially identical, that said fifth (N2) and sixth (N3) transistors are substantially identical, that said control electrodes are the gate electrodes of the MOS transistors, and that the Width-by-Length W/L channel parameter of said fifth (N2) and sixth (N3) transistors is relatively much larger than that of said fourth (N1) and seventh (N4) transistors.

3. Current source (BS) according to claim 2, characterized in that said fourth (N1) to seventh (N4) transistors are all diode-connected.

4. Current source (BS) according to claim 2, characterized in that said first (P1) and third (P2) transistors are PMOS transistors, that said second (N5), fourth (N1), fifth (N2), sixth (N3) and seventh (N4) transistors are NMOS transistors, and that both said first (P1, N5) and second (N1 to N4) branches are coupled in parallel between a first (VDD) and a second (VSS) voltage supply terminals, the voltage at said first voltage supply terminal (VDD) being more positive than that at said second voltage supply terminal (VSS).

## Patentansprüche

1. Stromquelle (BS), einen ersten Zweig (P1, N5) enthaltend, der aus der Reihenschaltung eines als Diode geschalteten ersten Transistors (P1) eines ersten Polaritätstyps (P) mit einem zweiten Steuertransistor (N5) eines zweiten Polaritätstyps (N) gebildet wird, wobei die Steuerelektrode des ersten Transistors (P1) mit der eines dritten Transistors (P2) des ersten Polaritätstyps (P) verbunden ist, und einer mit dem zweiten Steuertransistor (N5) verbundenen Vorspannungsschaltung (N1, N2, N3, N4), um den durch diesen fließenden Strom konstant zu halten und dadurch auch den Strom, der durch den dritten Transistor (P2) fließt, dadurch gekennzeichnet, daß die Vorspannungsschaltung durch einen zweiten Zweig (N1 bis N4) gebildet wird, der zu dem ersten Zweig (P1, N5) parallelgeschaltet ist und aus der Reihenschaltung eines vierten (N1), fünften (N2), sechsten (N3) und siebenten (N4) Transistors besteht, die alle vom zweiten Polaritätstyp (N) sind, wobei die Steuerelektrode des fünften Transistors (N2) mit der Steuerelektrode des zweiten Steuertransistors (N5) verbunden ist.

2. Stromquelle (BS) gemäß Anspruch 1, dadurch gekennzeichnet, daß alle diese Transistoren MOS-Transistoren sind, daß der vierte (N1) und der siebente (N4) Transistor im wesentlichen gleich sind, daß der fünfte (N2) und der sechste (N3) Transistor im wesentlichen gleich sind, daß die Steuerelektroden die Gate-Elektroden der MOS-Transistoren sind und daß der Breite-zu-Länge-Kanalparameter des fünften (N2) und sechsten (N3) Transistors im Verhältnis sehr viel größer ist als der des vierten (N1) und siebenten (N4) Transistors.

3. Stromquelle (BS) gemäß Anspruch 2, dadurch gekennzeichnet, daß die Transistoren vom vierten bis siebenten Transistor als Dioden geschaltet sind.

4. Stromquelle (BS) gemäß Anspruch 2, dadurch gekennzeichnet, daß der erste (P1) und der dritte (P2) Transistor PMOS-Transistoren sind, daß der zweite (N5), vierte (N1), fünfte (N2), sechste (N3) und siebente (N4) Transistor NMOS-Transistoren sind, und daß sowohl der erste (P1, N5) als auch der zweite (N1 bis N4) Zweig zwischen einen ersten (VDD) und einen zweiten (VSS) Versorgungsspannungsanschluß parallelgeschaltet sind, wobei die Spannung des ersten Versorgungsspannungsanschlusses (VDD) positiver ist als die des zweiten Versorgungsspannungsanschlusses (VSS).

**Revendications**

1. Source de courant (BS) comprenant une première branche (P1, N5) constituée par la connexion en série d'un premier transistor raccordé en diode (P1) d'un premier type de polarité (P) et d'un deuxième transistor de commande (N5) d'un second type de polarité (N), l'électrode de commande dudit premier transistor (P1) étant raccordée à celle d'un troisième transistor (P2) dudit premier type de polarité (P), et un circuit de polarisation (N1, N2, N3, N4) associé audit deuxième transistor de commande (N5) pour maintenir constant le courant y circulant et par conséquent le courant circulant au travers dudit troisième transistor (P2), caractérisé en ce que ledit circuit de polarisation est formé par une seconde branche (N1 à N4) couplée en parallèle avec ladite première branche (P1, N5) et constituée par la connexion en série d'un quatrième (N1), cinquième (N2), sixième (N3) et septième (N4) transistors tous dudit second type de polarité (N), l'électrode de commande dudit cinquième transistor (N2) étant raccordée à l'électrode de commande dudit second transistor de commande (N5).

2. Source de courant (BS) selon la revendication 1, caractérisée en ce que tous lesdits transistors sont des transistors MOS, que lesdits quatrième (N1) et septième (N4) transistors sont substantiellement identiques, que lesdits cinquième (N2) et sixième (N3) transistors sont substantiellement identiques, que lesdites électrodes de commande sont les portes des transistors MOS, et que le paramètre Largeur-par-Longueur W/L de canal desdits cinquième (N2) et sixième (N3) transistors est relativement beaucoup plus grand que celui desdits quatrième (N1) et septième (N4) transistors.

3. Source de courant (BS) selon la revendication 2, caractérisée en ce que les transistors, du quatrième (N1) au septième (N4), sont tous raccordés en diode.

4. Source de courant (BS) selon la revendication 2, caractérisée en ce que lesdits premier (P1) et troisième (P2) transistors sont des transistors PMOS, que lesdits second (N5), quatrième (N1), cinquième (N2), sixième (N3) et septième (N4) transistors sont des transistors NMOS, et que lesdites première (P1, N5) et seconde (N1 à N4) branches sont toutes deux couplées en parallèle entre un premier (VDD) et un second (VSS) terminal d'alimentation en tension, la tension audit premier terminal d'alimentation en tension (VDD) étant plus positive que celle audit second terminal d'alimentation en tension (VSS).

FIG. 1

FIG.2

FIG.3

FIG.4

FIG.5